Europäisches Patentamt

European Patent Office

Office européen des brevets

(19)

(11) Veröffentlichungsnummer: **0 684 462 A2**

## (12) EUROPÄISCHE PATENTANMELDUNG

(21) Anmeldenummer: **95106968.1**

(22) Anmeldetag: **08.05.95**

(51) Int. Cl.6: **G01K 7/02**, H01L 49/00, H01L 27/16

(30) Priorität: **25.05.94 DE 4418207**

(43) Veröffentlichungstag der Anmeldung:
**29.11.95 Patentblatt 95/48**

(84) Benannte Vertragsstaaten:
**DE FR GB IT**

(71) Anmelder: **SIEMENS AKTIENGESELLSCHAFT**
**Wittelsbacherplatz 2**
**D-80333 München (DE)**

(72) Erfinder: **Hierold, Christofer, Dr.**
**Ainmillerstrasse 38**
**D-80801 München (DE)**

(54) Thermischer Sensor/Aktuator in Hableitermaterial.

(57) Halbleiterbauelement mit monolithisch integrierten elektronischen Schaltungen und monolithisch integriertem Sensor/Aktuator, bei dem der Sensor/Aktuator mit Methoden des Surface-Micromachining hergestellt ist in einer z. B. mit Sensorstegen (6) strukturierten Sensorschicht (3) aus Polysilizium und diese Sensorstege (6) von einem Siliziumsubstrat (1) durch einen in einer Opferschicht (2) hergestellten und mit einer Verschlußschicht (5) nach außen gasdicht verschlossenen Hohlraum (4) thermisch isoliert sind.

FIG 1

EP 0 684 462 A2

EP 0 684 462 A2

Die vorliegende Erfindung betrifft ein Halbleiterbauelement, insbesondere aus Silizium, mit einem darin monolithisch integrierten Sensor oder Aktuator.

Die monolithische Integration von einem thermischen Sensor zusammen mit elektronischen Schaltungen für die Ansteuerung bzw. Auswertung auf einem Siliziumwafer und die gleichzeitige Herstellung der integrierten Komponenten in einem Standardprozeß bringt erhebliche Vorteile in bezug auf Funktionseigenschaften, Zuverlässigkeit, Miniaturisierung und Vereinfachung der Herstellung dieser Bauelemente. Thermische Sensoren wie z. B. Temperatursensoren, thermische Massenflußsensoren und thermische Strahlungssensoren und Aktuatoren wie z. B. Heizelemente müssen bestmöglich vom Substrat des Bauelementes thermisch isoliert sein, um sowohl die Wärmekapazität als auch die Wärmeleitfähigkeit zum Substrat zu minimieren. Das ist erforderlich, um die Ansprechgeschwindigkeit des Sensorelementes zu minimieren und dessen Empfindlichkeit zu maximieren. Außerdem soll die für eine bestimmte Temperaturdifferenz erforderliche Wärmemenge reduziert werden.

Bisherige Ansätze zur thermischen Isolation von Sensoren in Halbleiterbauelementen mit darin monolithisch integrierten Schaltungen bedienen sich der Methoden des Bulk-Micromachining. In der Veröffentlichung von D. Moser e.a.: "Silicon Gas Flow Sensors Using Industrial CMOS and Bipolar IC Technology" in Sensors and Actuators A,25 - 27, 577 bis 581 (1991) ist ein Gasflußsensor beschrieben, bei dem den Seebeck-Effekt ausnutzende Aluminium-Polvsilizium-Thermopaare zusammen mit CMOS-Schaltungen integriert sind. Bei der Herstellung dieses Bauelementes wird das Siliziumsubstrat von der Vorderseite mit einer anisotropen Ätzung selektiv gegenüber den Sensorschichten entfernt. Dadurch entstehen tiefe Löcher oder Gräben im Siliziumsubstrat. Bei dem in der Veröffentlichung von E. Yoon e.a.: "An Integrated Mass Flow Sensor with On-Chip CMOS Interface Circuitry" in IEEE Trans. on Electr. Dev. 39, 1376 bis 1386 (1992) beschriebenen integrierten Massenflußsensor wird das Substrat von der Rückseite her ausgeätzt. Die thermischen Sensoren liegen dann auf einer Membran z. B. aus Oxid oder Siliziumnitrid auf der Chipoberfläche und sind nur noch über diese Membran mit dem Substrat thermisch gekoppelt. Durch die Strukturierung der Rückseite sind spezielle Montagetechniken notwendig.

Bei Ätzung von der Vorderseite werden die Sensorelemente meist als Brücken oder Cantilever realisiert, die über die geätzten Löcher oder Aussparungen gespannt sind bzw. in diese hineinragen. Die thermische Isolation der Sensoren erfolgt über das umgebende Medium (z. B. Stickstoff) und die meist dünnen Aufhängungen der Brücken oder Cantilever. Die tiefen Löcher oder Gräben im Substrat können durch Partikel sehr leicht verschmutzen. Diese Partikel werden z. B. in Durchflußsensoren von dem Gasstrom mitgeführt.

Aufgabe der vorliegenden Erfindung ist es, ein Halbleiterbauelement mit einem integrierten thermischen Sensor oder Aktuator anzugeben, bei dem die thermische Isolation des Sensors oder Aktuators in verbesserter Weise erfolgt und ein zugehöriges Herstellungsverfahren kompatibel mit dem Herstellungsprozeß monolithisch integrierter elektronischer Schaltungen ist. Dieses Herstellungsverfahren soll ebenfalls angegeben werden.

Diese Aufgabe wird mit dem Halbleiterbauelement mit den Merkmalen des Anspruches 1 bzw. mit dem Herstellungsverfahren mit den Merkmalen des Anspruches 11 gelöst. Weitere Ausgestaltungen ergeben sich aus den abhängigen Ansprüchen.

Bei dem erfindungsgemäßen thermischen Sensor erfolgt die Herstellung des Sensors in einer mit Methoden des Surface-Micromachining bearbeitbaren Oberflächenschicht eines Bauelementes, das vorzugsweise auf Silizium hergestellt wird. Die den Sensor bildende Struktur befindet sich in einem schichtartigen Bereich und ist von dem restlichen Halbleitermaterial des Bauelementes durch einen Hohlraum in einer als Opferschicht fungierenden Zwischenschicht thermisch isoliert. Dieser Hohlraum wird durch eine Verschlußschicht, in die der schichtartige Bereich eingebettet ist, nach außen verschlossen. Es folgt eine Beschreibung verschiedener Ausführungsformen dieses Bauelementes sowie der Herstellungsverfahren anhand der Figuren.

Figur 1          zeigt einen Querschnitt durch ein erfindungsgemäßes Bauelement.

Figur 2          zeigt einen Querschnitt durch eine alternative Ausführungsform des erfindungsgemäßen Bauelementes.

Figuren 3 bis 6  zeigen Zwischenstufen bei der Herstellung eines erfindungsgemäßen Bauelementes im Querschnitt.

Figur 6          zeigt eine dritte Ausführungsform des erfindungsgemäßen Bauelementes.

Figur 7          zeigt eine schematisierte Aufsicht auf einen erfindungsgemäßen Massenflußsensor.

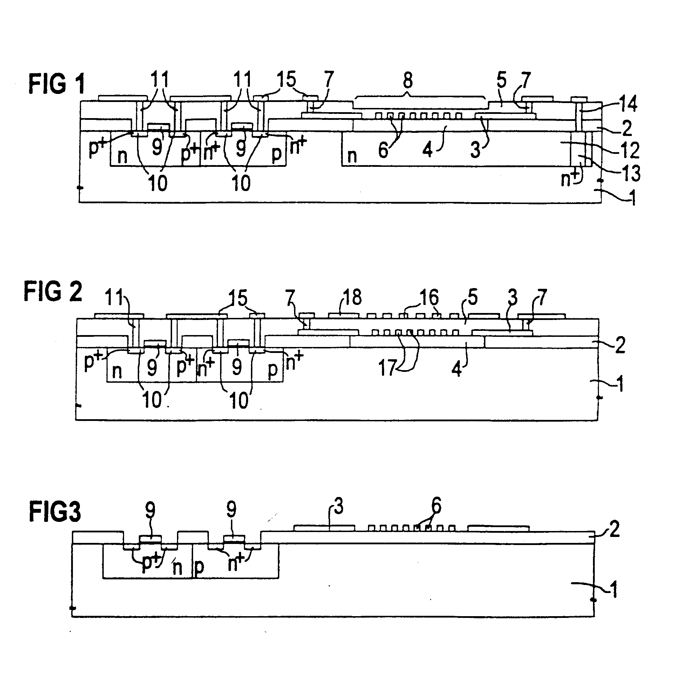

In Figur 1 ist ein Bauelement dargestellt, bei dem auf einem Substrat 1 eine für die Herstellung des Hohlraumes 4 vorgesehene Opferschicht 2 und eine Sensorschicht 3 aufgebracht sind. Der Hohlraum 4 wird durch eine Verschlußschicht 5 abgedichtet. Über dem Hohlraum 4 sind in dem Sensorbereich 8 Sensorstege 6 als Bestandteil der Sensorschicht 3 vorhanden. Die Sensorstege 6 sind elektrisch leitend miteinander

2

und mit auf den Anschlußflächen der Sensorschicht 3 aufgebrachten Kontakten 7 verbunden. Die Sensorstege 6 sind in die Verschlußschicht 5 eingebettet und überspannen den Hohlraum 4, wobei entweder nur ein Ende auf der Opferschicht 2 aufliegt (Cantilever) oder beide Enden der Sensorstege 6 auf den Rändern der Opferschicht 2 aufliegen (Brücken). Die Strukturierung der Sensorschicht 3 ist hier nur als Beispiel angegeben. Der Sensor ist allgemein als strukturierte Schicht über dem Hohlraum 4 ausgebildet. Diese strukturierte Schicht umfaßt z. B. die in Figur 1 gezeichneten Stege aus einem elektrisch leitfähigen Material mit temperaturabhängigem ohmschem Widerstand oder Thermopaare. Statt dessen oder zusätzlich kann diese strukturierte Schicht aktive Bauelemente wie Dioden oder Transistoren, die als Heizer oder Sensor fungieren, umfassen.

In dem Substrat 1 können weitere Bauelemente, insbesondere aktive, mit denen z. B. die Ansteuer- und Auswerteschaltungen aufgebaut sind, monolithisch integriert sein. In dem in Figur 1 gezeichneten Beispiel sind zwei komplementäre MOS-Transistoren vorhanden. In für zueinander komplementäre Transistoren vorgesehene dotierte Bereiche (n-Wanne und p-Wanne) sind Source- und Drain-Bereiche 10 implantiert. Dazwischen befindet sich auf einer Oxidschicht je eine Gate-Elektrode 9 z. B. aus Polysilizium. Die Gate-Elektroden 9 sind lateral kontaktiert. Die Kontakte 11 für Source und Drain sind in Figur 1 eingezeichnet. Auf der Oberseite der planarisierenden Verschlußschicht 5, die ggf. durch eine weitere Schicht abgedeckt sein kann, befindet sich eine Metallisierung 15, die als erste Metallisierungsebene fungiert und den elektrischen Anschluß der verschiedenen Kontakte ermöglicht. Ergänzend befindet sich in Figur 1 unterhalb des Sensorbereiches 8 im Substrat 1 ein dotierter Bereich 12 mit einem daran angrenzenden hoch dotierten Anschlußbereich 13, auf dem ein Kontakt 14 aufgebracht ist. Dieser dotierte Bereich 12 kann als Gegenelektrode zu der elektrisch leitfähigen Sensorschicht 3 verwendet werden. Auf diese Weise erhält man einen kombinierten Temperatur-Druck-Sensor, wenn die Sensorschicht 3 und die Verschlußschicht 5 im Sensorbereich 8 so elastisch (z. B. ausreichend dünn) ausgebildet sind, daß sich bei Änderung des äußeren Druckes der Abstand zwischen der Sensorschicht 3 und dem dotierten Bereich 12 im Sensorbereich 8 derart ändert, daß eine Änderung der elektrischen Kapazität zwischen der Sensorschicht 3 und dem dotierten Bereich 12 festgestellt und ausgewertet werden kann. Um die bessere Beweglichkeit der Sensorstege 6 in der Verschlußschicht 5 zu gewährleisten, kann diese Verschlußschicht 5 in dem Sensorbereich 8 wie gezeichnet dünner geätzt sein. Die in die Verschlußschicht 5 eingebettete strukturierte Sensorschicht 3 kann gleichermaßen für einen Aktuator vorgesehen sein.

Bei dem Ausführungsbeispiel der Figur 2 befinden sich auf dem Substrat 1 die Opferschicht 2 mit dem darin hergestellten Hohlraum 4 und darauf die strukturierte Sensorschicht 3 mit der Verschlußschicht 5. Die Verschlußschicht 5 besitzt hier eine planare Oberfläche, auf der die Metallisierung 15 aufgebracht ist. Ein Anteil dieser Metallisierung 15 befindet sich in strukturierter Form über den Sensorstegen 17. Die Strukturierung der Metallisierung besteht hier z. B. aus streifenförmigen Leiterbahnen 16 und Anschlußflächen 18 für elektrischen Anschluß. Die Leiterbahnen 16 sind untereinander und mit den Anschlußflächen 18 elektrisch leitend verbunden und so gestaltet, daß sie bei Anlegen eines Betriebsstromes als Heizelemente wirken. Wenn die Sensorschicht 3 Polysilizium ist, ist es wegen des höheren Schichtwiderstandes des Polysiliziums und des höheren Temperaturkoeffizienten für den elektrischen Widerstand der metallischen Leiterbahnen vorteilhaft, die Sensorstege 17 als Heizer und die Leiterbahnen 16 als Sensor zu verwenden. Die umgekehrte Betriebsweise ist aber auch möglich. Der Abstand zwischen Heizer und Sensor ist so gering, daß der Sensor eine Temperaturänderung gegenüber einer mit dem Heizer eingestellten Normtemperatur feststellen kann. Mit einer solchen Sensor-Heizer-Kombination kann die Effizienz des Sensors verbessert werden und durch die geeignete Wahl der Normtemperatur insbesondere an einen bestimmten Temperaturbereich besser angepaßt werden. Grundsätzlich ist es auch möglich, Heizer und Sensor in derselben Schichtebene der Sensorschicht 3 z. B. kammartig gegeneinander verzahnt, aber elektrisch voneinander isoliert anzuordnen.

Ein schematisierter Herstellungsprozeß eines erfindungsgemäßen Sensors/Aktuators wird anhand der Figuren 3 bis 6 beschrieben. Die schichtartige Struktur dieses Sensors bzw. Aktuators ist besonders geeignet, mit den Methoden des Surface-Micromachining innerhalb eines standardisierten CMOS/BiCMOS-Prozesses hergestellt zu werden. Surface-Micromachining ist eine Methode zur Herstellung von mikromechanischen Strukturen auf der Oberfläche eines Chips, insbesondere eines Siliziumchips, unter Verwendung von sogenannten Opferschichten, d. h. Schichten die nur der Strukturierung dienen und im Verlauf des Verfahrens ganz oder teilweise entfernt werden. In Figur 3 ist im Querschnitt ein Substrat 1 mit darin implantierten dotierten Bereichen für die Herstellung von MOS-Transistoren dargestellt. Diese Transistorbereiche sind nur der Veranschaulichung der gemeinsamen Integration von Ansteuerelementen und Sensoren halber eingezeichnet. Im Prinzip können in dem Substrat 1 beliebige elektronische Bauelemente monolithisch integriert sein. Auf der Oberseite ist die Opferschicht 2 z. B. aus einem Oxid ganzflächig aufgebracht. Über den für die Transistoren dotierten Bereichen (sogenannte n-Wanne und p-Wanne) ist diese Opferschicht 2 jeweils bis auf das Substrat geöffnet. In diesen Öffnungen in der Opferschicht 2 sind das Gate-Oxid und Gate-Elektroden 9 z. B. aus Polysilizium aufgebracht und Implantierungen für hoch dotierte Bereiche für Source und Drain eingebracht. Die Herstellung erfolgt mit Standardprozeßschritten eines CMOS-oder BiCMOS-Prozesses. Auf der Oberseite der Opferschicht 2 wird in dem für den Sensor bzw. Aktuator vorgesehenen Bereich eine für die Funktion als Sensor bzw. Aktuator strukturierte Schicht hergestellt, die in diesem Beispiel in einer mit Sensorstegen 6 strukturierten Sensorschicht 3 z. B. aus Polysilizium besteht und vorteilhaft zusammen mit den Gate-Elektroden 9 in denselben Prozeßschritten hergestellt wird. Die Sensorstege 6 sind miteinander verbunden und bilden z. B. eine kammartige Struktur aus mäanderförmig verlaufenden und im wesentlichen parallel zueinander angeordneten Polysiliziumbahnen. Diese Bahnen oder Streifen, die in Figur 3 im Querschnitt als Polysiliziumstege 6 gezeichnet sind, wobei der Übersichtlichkeit halber die in Blickrichtung vorhandenen Querverbindungen dieser Sensorstege 6 weggelassen sind, bilden Leiterbahnen mit temperaturabhängigem elektrischem Widerstand. Bei Verwendung dieser Struktur als Sensor wird die temperaturabhängige Änderung eines angelegten und durch die Polysiliziumstege fließenden Stromes gemessen. Bei Verwendung der Struktur als Aktuator (Heizer) wird ein Strom angelegt, der diese Leiterbahnen aus Polysilizium aufheizt, so daß der Aktuator als Widerstandsheizung arbeitet. Statt dieser Polysiliziumstege können z. B. Stege aus Metallisierung (z. B. AlSiCu oder Wo, ggf. mit Diffusionsbarriere aus Ti/TiN), Aluminium-Polysilizium-Thermopaare, Polysilizium-Polysilizium-Thermopaare, Dioden oder Transistoren (als Heizer oder Sensoren) in Polysilizium oder eine Verbindung dieser Komponenten in einer strukturierten Schicht vorhanden sein.

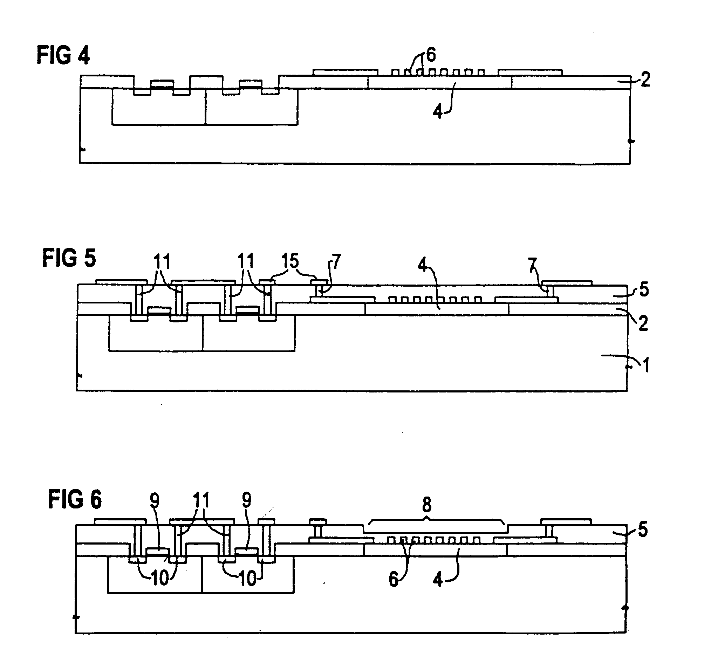

Nachdem diese strukturierte Schicht hergestellt ist, d. h. in vorliegendem Ausführungsbeispiel die Sensorschicht 3 aus Polysilizium mit Sensorstegen 6 strukturiert ist, wird mit Hilfe einer Ätzmaske (z. B. Lack oder Siliziumnitrid) und einer isotropen Ätze (z. B. HF, HF-Dampf) in dem für den Sensor/Aktuator vorgesehenen Bereich die Opferschicht 2 selektiv gegen das Material (z. B. Silizium) des Substrates 1 entfernt. Der ausgeätzte Bereich wird dabei so bemessen, daß die Sensorstege 6 an Enden (z. B. den Mäanderkurven) auf den verbliebenen Anteilen der Opferschicht 2 aufliegen. Da wo die Opferschicht 2 weggeätzt ist, befindet sich unter der Sensorschicht 3 jetzt eine für den Hohlraum 4 vorgesehene Aussparung (s. Figur 4).

Wie in Figur 5 dargestellt, wird die Oberseite dann ganzflächig mit einer Verschlußschicht 5 z. B. aus einem Oxid bedeckt und planarisiert. Ggf. kann hier eine Schicht aus verschiedenen Schichtanteilen oder eine gesonderte Planarisierungsschicht auf der Oberseite zusätzlich vorgesehen sein. Die Verschlußschicht kann z. B. Borphosphorsilikatglas sein, das mittels APCVD abgeschieden wird und das man anschließend durch eine RTP-Temperung verfließen läßt. Dabei werden die Zwischenräume zwischen den Anteilen der Sensorschicht 3 im Bereich des Sensors gasdicht verschlossen. Unter der Verschlußschicht bleibt in dem Sensorbereich der Hohlraum 4, in dem wegen der Abscheidung bei niedrigem Druck und der möglichen Reaktion von Gasrückständen mit dem Silizium ein sehr niedriger Gasdruck herrscht. Dieser Hohlraum besitzt daher eine extrem niedrige Wärmeleitfähigkeit und isoliert daher die Sensor-/Aktuator-Schicht sehr gut thermisch von dem Material des Substrates 1. Um zu erreichen, daß der Hohlraum 4 beim Abscheiden der Verschlußschicht 5 nicht mit dem Material der Verschlußschicht 5 mit aufgefüllt wird, werden die Zwischenräume zwischen den Sensorstegen ausreichend klein gewählt. Ggf. kann außerdem das Material der Verschlußschicht 5 schräg abgeschieden werden, so daß diese Zwischenräume zwischen den Sensorstegen durch die Sensorstege zumindest teilweise abgeschattet werden. Der Abstand zwischen den Sensorstegen sollte dafür nicht größer als etwa 2 μm betragen. Allgemein kann davon ausgegangen werden, daß die Weite der Zwischenräume in der für den Sensor bzw. Aktuator vorgesehenen strukturierten Schicht nirgends in jeder in der Ebene dieser Schicht verlaufenden Richtung mehr als 2 μm betragen sollte. Für die elektrischen Anschlüsse werden in der Verschlußschicht 5 Öffnungen ausgeätzt und mit Metall gefüllt. Dann kann auf die Oberseite eine Metallisierung 15 als erste Metallisierungsebene und ggf. mit Dielektrikumschichten voneinander getrennte weitere Metallisierungsebenen aufgebracht werden. Die Verschlußschicht 5 kann alternativ als Plasmaoxid, oder Plasmanitrid mit nachfolgendem SOG abgeschieden werden. Verschiedene Prozeßvarianten für unterschiedliche verwendete Materialien sind beispielhaft in der nachfolgenden Tabelle aufgelistet.

4

| Oxid | Abscheidung | Druck | Temperatur | Einsatz für: |
|------|-------------|-------|------------|--------------|
| BPSG | APCVD, geringe Konformität, dann | Atmosphäre | ca. 430 °C | **PolySi**, Wolfram |
| | Verfließen durch RTP-Temperung: vollständig verschlossen | low pressure: einige 10 mbar | ca. 1100 °C 10 sec | **PolySi**, Wolfram |
| Plasmaoxid Plasmanitrid | aus Plasma, gerichtet, evtl. schräg, vollständig verschlossen | low pressure: einige 10 mbar | ca. 350 °C | PolySi, **AlSiCu**, Wolfram, |
| TEOS | LPCVD, konform, vollständig verschlossen | low pressure: einige 10 mbar | ca. 730 °C | PolySi, Wolfram |
| Ozon-TEOS | LPCVD, konform vollständig verschlossen | low pressure: einige 10 mbar | ca. 300 °C | PolySi, Wolfram AlSiCu |

Figur 6 zeigt das fertige Halbleiterbauelement, bei dem nach Abschluß der Standardprozessierung für den elektrischen Anschluß die Verschlußschicht 5 im Sensorbereich 8 durch einen Rückätzschritt gedünnt wurde (z. B. Trockenätzung). Dadurch wird die Wärmekapazität und damit die Ansprechzeit des Sensors/Aktuators reduziert und die durch den Hohlraum 4 bewirkte thermische Isolation zum Substrat 1 in ihrer Wirksamkeit weiter verbessert. Auf diese Weise lassen sich thermische Sensoren bzw. Aktuatoren monolithisch mit elektronischen Bauelementen oder Schaltungen integrieren, wobei jeder Sensor/Aktuator gegenüber dem Halbleitermaterial des Substrates und anderer integrierter Komponenten thermisch und elektrisch isoliert und gegenüber der Umgebung durch eine abdeckende Schutzschicht gegen Verschmutzung geschützt ist und außerdem eine weitgehend planare Oberfläche besitzt. Fur die Herstellung muß der CMOS- oder BiCMOS-Standardprozeß nur um eine zusätzliche Maske und ein oder zwei zusätzliche Ätzschritte erweitert werden.

Bei alternativen Ausführungsformen dieses erfindungsgemäßen Bauelementes kann für die Sensorschicht statt Polysilizium eine Metallisierung (z. B. AlSiCu oder Wo, ggf. mit Ti/TiN-Barriere) vorgesehen werden. Insbesondere können in der Ausführungsform der Figur 2 auch die Sensorstege 17 durch eine Metallisierung gebildet sein. Wird die Oberfläche des Sensors mit einer strahlungsabsorbierenden Schicht versehen, so erhält man einen thermischen Strahlungssensor.

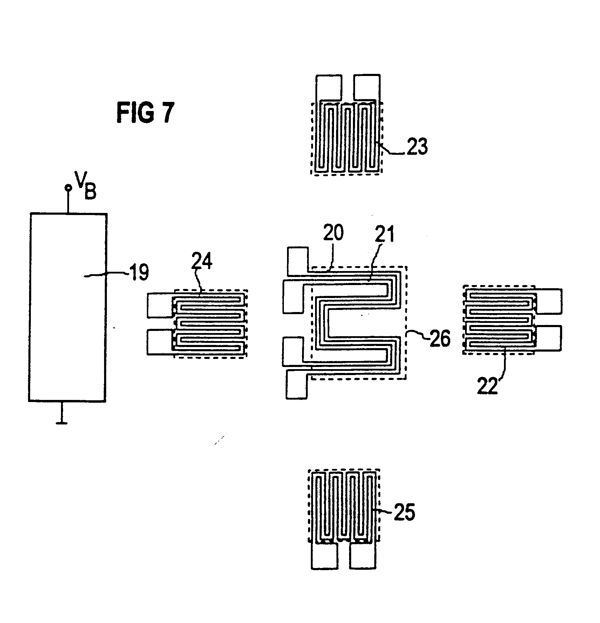

Figur 7 zeigt ein Ausführungsbeispiel des erfindungsgemäßen Halbleiterbauelements als Massenflußsensor in der Aufsicht. Die elektronische Schaltung 19, die der Ansteuerung der Sensoren und der Auswertung der Meßsignale dient, ist hier schematisch durch den rechteckig berandeten Bereich bezeichnet. In dem Sensor-Aktuator-Bereich befindet sich ein Heizer 20, der benachbart zu einem ersten Sensor 21 angeordnet ist. Ein zweiter Sensor 22, ein dritter Sensor 23, ein vierter Sensor 24 und ein fünfter Sensor 25 sind in einem größeren Abstand rings um den Heizer 20 angeordnet. Die verdeckten Konturen der diese Sensoren von dem Substrat thermisch isolierenden Hohlräume 26 sind mit gestrichelten Linien eingezeichnet. Bei diesem Array von Sensoren mißt der erste Sensor 21 die vom Massenfluß abhängige Temperaturabnahme des Heizers 20 und bestimmt damit den Betrag des Massenflusses. Mit den übrigen vier Sensoren 22, 23, 24, 25 kann die Richtung des Flusses ermittelt werden. Die elektronische Schaltung 19, die monolithisch integriert ist, umfaßt Meß- und Ansteuerschaltungen, liefert die erforderlichen Betriebsströme und wertet die von den fünf Sensoren kommenden Meßsignale aus. Statt mit dem Heizer 20 eine Normtemperatur einzustellen, deren Änderung bei Massenfluß von dem ersten Sensor 21 erfaßt wird, kann der Heizer 20 z. B. durch eine Stromregelschaltung auf konstante Temperatur eingestellt werden. Diese vorgegebene konstante Temperatur wird von dem ersten Sensor 21 kontrolliert, und bei einer Änderung wird die Stromstärke für den Heizer 20 so nachreguliert, daß diese Temperaturänderung kompensiert wird. Aus der erforderlichen Änderung der Stromstärke kann dann der Massendurchfluß indirekt bestimmt werden. Verzichtet man auf die Ermittlung der Flußrichtung, so ist die Kombination von Heizer 20 und erstem Sensor 21 allein eine vereinfachte Ausführung dieses Massenflußsensors.

**Patentansprüche**

1. Thermischer Sensor/Aktuator in Halbleitermaterial, bei dem für die Funktion als Sensor/Aktuator eine strukturierte Schicht (3, 6) vorhanden ist,
bei dem diese strukturierte Schicht durch einen Hohlraum (4) von übrigem Halbleitermaterial thermisch isoliert ist und bei dem dieser Hohlraum nach außen durch eine Verschlußschicht (5) verschlossen ist.

2. Halbleiterbauelement nach Anspruch 1,
bei dem die strukturierte Schicht in die Verschlußschicht (5) eingebettet ist.

3. Halbleiterbauelement nach Anspruch 1 oder 2,
bei dem die strukturierte Schicht vorwiegend durch Polysilizium gebildet ist.

4. Halbleiterbauelement nach einem der Ansprüche 1 bis 3,
bei dem die strukturierte Schicht elektrische Leiter umfaßt, bei dem auf der der Verschlußschicht (5) gegenüberliegenden Seite des Hohlraumes (4) ein elektrisch leitfähig dotierter Bereich (12) vorhanden ist,
bei dem dieser dotierte Bereich (12) mit einem Kontakt (14) elektrisch leitend verbunden ist und
bei dem die strukturierte Schicht und die Verschlußschicht (5) über dem Hohlraum (4) so elastisch ausgebildet sind, daß bei einer Änderung des äußeren Druckes eine Änderung der elektrischen Kapazität zwischen der strukturierten Schicht und dem dotierten Bereich (12) feststellbar ist.

5. Halbleiterbauelement nach einem der Ansprüche 1 bis 4,
bei dem der Hohlraum (4) sich in einer Aussparung einer gesonderten Schicht befindet.

6. Halbleiterbauelement nach Anspruch 5,
bei dem diese gesonderte Schicht eine Dielektrikumschicht ist.

7. Halbleiterbauelement nach einem der Ansprüche 1 bis 6,
bei dem auf der dem Hohlraum abgewandten Seite der Verschlußschicht (5) eine Metallisierung (15) vorhanden ist und bei dem zu dieser Metallisierung Leiterbahnen gehören, die von der strukturierten Schicht des Sensors/Aktuators elektrisch isoliert sind und die so gestaltet sind, daß sie als Sensor/Aktuator betrieben werden können.

8. Halbleiterbauelement nach einem der Ansprüche 1 bis 7,
monolithisch integriert mit weiteren Halbleiterbauelementen für elektrische Ansteuerung des Sensors/Aktuators.

9. Halbleiterbauelement nach einem der Ansprüche 1 bis 8,
bei dem der Sensor/Aktuator durch zwei separate Anteile gebildet wird, von denen einer als Sensor und einer als Heizer betrieben werden kann, und
bei dem dieser Sensor und dieser Heizer so dicht benachbart zueinander angeordnet sind, daß mit dem Heizer eine von dem Sensor meßbare Normtemperatur eingestellt werden kann.

10. Halbleiterbauelement nach einem der Ansprüche 1 bis 9,
bei dem der Sensor/Aktuator Teil eines Arrays aus voneinander getrennten Sensoren/Aktuatoren ist.

11. Verfahren zur Herstellung eines Halbleiterbauelementes nach einem der Ansprüche 1 bis 10, bei dem
in einem ersten Schritt auf einem Substrat (1) aus Halbleitermaterial eine für vorgesehene Betriebsweisen des Bauelementes erforderliche Struktur aus Halbleitermaterial hergestellt wird,
in einem zweiten Schritt die für einen Sensor/Aktuator vorgesehene strukturierte Schicht (3, 6) so hergestellt wird, daß sie in der Schichtebene durch für einen nachfolgenden vierten Schritt ausreichend kleine Zwischenräume unterbrochen ist,
in einem dritten Schritt unter Ausnutzung dieser Zwischenräume eine für den Hohlraum (4) vorgesehene Aussparung unter der strukturierten Schicht hergestellt wird,
in einem vierten Schritt bei einem dem herzustellenden Hohlraum entsprechend niedrigen Gasdruck ganzflächig eine Verschlußschicht (5) abgeschieden wird, die diese Zwischenräume verschließt, so daß in dieser Aussparung ein Hohlraum (4) verbleibt, und

in einem fünften Schritt Kontakte (7) für elektrischen Anschluß des Sensors/Aktuators hergestellt werden.

12. Verfahren nach Anspruch 11, bei dem
zwischen dem ersten und dem zweiten Schritt ganzflächig eine Opferschicht (2) aufgebracht wird und in dem dritten Schritt die Aussparung in dieser Opferschicht (2) hergestellt wird.

13. Verfahren nach Anspruch 11 oder 12, bei dem
in dem zweiten Schritt die für den Sensor/Aktuator vorgesehene strukturierte Schicht (3, 6) mit Methoden des Surface-Micromachining (mikromechanische Oberflächenstrukturierung) hergestellt wird.

14. Verfahren nach einem der Ansprüche 11 bis 13, bei dem
in dem zweiten Schritt die strukturierte Schicht mit Zwischenräumen hergestellt wird, die nirgends in allen in der Ebene dieser Schicht verlaufenden Richtungen eine Abmessung von mehr als 2 $\mu$m haben.

FIG 1

FIG 2

FIG3

## FIG 4

## FIG 5

## FIG 6

FIG 7